# EUROPEAN PATENT APPLICATION

(11) **EP 1 601 003 A2**
(43) Date of publication of application: **30.11.2005**
(21) Application number: 05006546.5
(22) Date of filing: 24.03.2005
(51) Int. Cl.: H01J 61/34, H01J 61/52, H01J 61/50, H01J 61/04

(54) **Ultraviolet ray generator, ultraviolet ray irradation processing apparatus, and semiconductor manufacturing system**

(30) Priority: 28.05.2004 JP 2004160113
(71) Applicant: National Institute of Advanced Industrial Science and Technology, Tokyo 100-8921 (JP); SEMICONDUCTOR PROCESS LABORATORY CO., LTD., Ichikawa-shi, Chiba 272-0001 (JP)
(72) Inventor: Ohdaira, Toshiyuki, National Institute of Advanced, Umezono Tsukuba-shi Ibaraki 305-8568 (JP); Shioya, Yoshimi Semiconductor Process Lab. Co. Ltd, Chiba 272-0001 (JP)
(74) Representative: Marx, Lothar

(57) **Abstract**

The present invention relates to an ultraviolet ray generator 101, and the generator 101 has an ultraviolet ray lamp 1, a protective tube 2 being made of a material which is transparent with respect to ultraviolet ray and housing the ultraviolet ray lamp 1, and gas introduction port 6a introducing nitrogen gas or inert gas into the protective tube 2.

## Description

### BACKGROUND OF THE INVENTION

### 1. Field of the Invention

The present invention relates to an ultraviolet ray generator, an ultraviolet ray irradiation processing apparatus, and a semiconductor manufacturing system.

### 2. Description of the Related Art

In recent years, an insulating film having low dielectric constant (hereinafter referred to as a low dielectric constant insulating film) has been used in a semiconductor integrated circuit in order to suppress delay of signals transmitting between wirings and to improve processing speed of the entire circuit.

A semiconductor roadmap requires an interlayer insulating film having the relative dielectric constant of 2.5 or less on and after a 65nm generation of a design rule. However, as a result of study on various types of insulative materials, it has made clear that it is difficult to realize the relative dielectric constant of 2.5 or less by a single material. For this reason, there has been used a method such as lowering an effective dielectric constant of the entire insulating film on the basis of an insulating material having the relative dielectric constant of 2.5 or less by reducing a film density in a manner such that pores ranging from nanometers to sub-nanometers are introduced into the formed insulating film to make the film porous.

For example, Patent Document 1 describes an example that sacrifical organic polymer is taken into the formed film and then it is removed from the film by oxidation or the like to make the film porous.

### (Patent Document 1) Japanese Patent Laid-open No.2000-273176 publication

However, when the pores are introduced into the insulating film to make it porous, there occurs a problem such that the mechanical strength of the entire film is drastically reduced and thus the film cannot withstand a polishing process (CMP: Chemical Mechanical Polishing) that is performed for the purpose of planarization in a process after film forming. To solve the problem, when a pore size is made smaller or porosity is reduced, the mechanical strength is increased, but low relative dielectric constant required is not obtained.

To solve such problem, it is considered that ultraviolet ray is irradiated onto the insulating film in low-pressure atmosphere, but a conventional ultraviolet ray lamp is designed based on the assumption that it is used in the atmosphere and therefore when the lamp is installed in the low-pressure atmosphere, there is a fear that the ultraviolet ray lamp cannot withstand pressure difference and thus will be broken. Further, when the outer wall of the ultraviolet ray lamp is made thicker, the lamp might not be broken, but there is a fear that the temperature of the outer wall could be too high because the ultraviolet ray lamp is placed in the low-pressure atmosphere.

To prevent this, an ultraviolet ray transmitting window made of quartz glass is provided in a manner such as fitting into the partition wall of a processing chamber so that the ultraviolet ray transmitting window contacts the low-pressure atmosphere, and thus ultraviolet ray is to be irradiated onto a substrate (being subject to film formation) through the ultraviolet ray transmitting window. In this case, it is necessary that the thickness of the ultraviolet ray transmitting window be set such that the window can withstand a stress caused by pressure difference applied to the ultraviolet ray transmitting window. Additionally, in the case where the substrate becomes larger-size or a plurality of substrates need to be processed simultaneously, it is necessary that a plurality of ultraviolet ray lamps be arranged on an opposing surface to the substrate in correspondence with the size of the substrate in order to irradiate ultraviolet ray evenly onto the substrate. In such a case, the conventional ultraviolet ray generator has a wide surface area of the ultraviolet ray transmitting window that contacts the low-pressure atmosphere, and thus the stress applied to the window becomes larger, so that the thickness of the ultraviolet ray transmitting window needs to be much thicker. This results in large attenuation of ultraviolet ray transmitting intensity and an increase in manufacturing cost of the apparatus.

### SUMMARY OF THE INVENTION

It is an object of the present invention to provide an ultraviolet ray generator, an ultraviolet ray irradiation processing apparatus, and a semiconductor manufacturing system, which can be used in a low-pressure atmosphere, can sufficiently withstand a stress caused by pressure difference, and are capable of reducing the attenuation of ultraviolet ray transmitting intensity while reducing the manufacturing cost of the apparatus.

According to the ultraviolet ray generator of the present invention, ultraviolet ray lamp is sealed or housed in protective tube made of a material through which ultraviolet ray passes or which is transparent with respect to ultraviolet ray. The material through which ultraviolet ray passes is quartz glass, for example.

Therefore, when the outside of the protective tube is decompressed, the protective tube can be made strong enough to withstand the stress caused by the pressure difference, and this prevents the ultraviolet ray lamps inside the protective tube from breaking.

Further, the ultraviolet ray lamp is sealed or housed one individually in the protective tube. Particularly, when a plurality of ultraviolet ray lamps are arranged and installed in the low-pressure atmosphere, the surface areas of the protective tubes, which contact the low-pressure atmosphere, can be made smaller, respectively. Accordingly, since the stress caused by the pressure difference applied to the protective tubes becomes smaller as well, it is possible to make the thickness of the protective tubes even thinner. Therefore, the attenuation of the ultraviolet ray transmitting intensity can be made even smaller and the cost of the ultraviolet ray generator can be reduced.

Furthermore, nitrogen gas or inert gas is previously charged into the protective tubes, in other words, in a gap between the ultraviolet ray lamp and a corresponding protective tube, or the protective tube has gas inlet port for introducing nitrogen gas or inert gas in the gap. Therefore, when ultraviolet ray is irradiated, the gap is in a state such that oxygen is not left, or the gap can be brought into oxygen-free state by filling the gap with nitrogen gas or the like. Thus, ultraviolet ray generated from the ultraviolet ray lamps can be emitted outside the protective tubes without being absorbed by oxygen. Further, since nitrogen gas or inert gas flows in the gap in a state such that it contacts the ultraviolet ray lamp, the gas cools down the ultraviolet ray lamp and can prevent temperature increase.

Moreover, since an electrode for discharge of an excimer ultraviolet ray lamp or the like, that generates ultraviolet ray through discharge, is exposed to the outside, the electrode contacts the outside air or the atmosphere inside the processing chamber and thus there is a fear of being oxidized or corroded. Such problem can be prevented by the protective tube.

Furthermore, by providing an ultraviolet ray reflective plate that allows ultraviolet ray generated from the ultraviolet ray generator to travel in a specific direction by reflection, the usage efficiency of ultraviolet ray can be improved when the substrate is placed on a side to which ultraviolet ray travels. The specific direction does not mean that all ultraviolet rays travel in a specific direction at a same angle, but means that the rays travel to the ultraviolet ray generator side in spite of the different angle of each ultraviolet ray when viewed from the ultraviolet ray reflective plate. The same applies to the following.

Meanwhile, to obtain a low dielectric constant insulating film having large mechanical strength, it is necessary to irradiate ultraviolet ray onto a formed film after film forming and cut off CH₃ group from Si-CH₃ bond in the insulating film without affecting the framework structure of Si-O-Si or the like. In such application, the upper limit of ultraviolet energy to be irradiated (that is, the lower limit of the wavelength of ultraviolet ray to be irradiated) needs to be set to the bond energy of Si-O-Si that forms the framework structure or Si-O other than Si-O-Si, and the lower limit of ultraviolet energy to be irradiated (that is, the upper limit of the wavelength of ultraviolet ray to be irradiated) needs to be set to energy larger than the bond energy of Si-CH₃ bond group. Since the present invention is provided with a filter that can select wavelength of a particular range of ultraviolet ray generated from the ultraviolet ray generator to allow the wavelength to pass through the filter, it is possible to set the energy (wavelength) of ultraviolet ray to be irradiated to the above-described range.

The ultraviolet ray irradiation processing apparatus of the present invention is provided with a substrate holder for holding the substrate in a processing chamber that can be decompressed, and the above-described ultraviolet ray generator in the processing chamber, which opposes the substrate holder.

Since the above-described ultraviolet ray generator can withstand the stress caused by the pressure difference even if the thickness of the protective tube is made thin, the attenuation of ultraviolet ray transmitting intensity can be suppressed and the cost of apparatus can be reduced.

Further, since the generator is provided with the ultraviolet ray reflective plate that allows ultraviolet ray to travel in a specific direction by reflection, the usage efficiency of ultraviolet ray can be improved, and power saving can be achieved.

Moreover, the generator is provided with the filter capable of selecting the ultraviolet ray of the wavelength of a particular range and allowing the ultraviolet ray of the wavelength to pass through the filter, so that after forming a film having CH₃ group in the framework structure of Si-O-Si or the like, the generator can irradiate the ultraviolet ray of the wavelength of a specific range onto the formed film. Therefore, CH₃ group can be cut off from Si-CH₃ bond in the insulating film without affecting a framework structure of Si-O-Si or the like, and thus it can result in a formation of a low dielectric constant insulating film having large mechanical strength.

Further, the substrate holder is capable of performing at least one of vertical movement, rotational movement to the ultraviolet ray generator, and reciprocal linear movement within an opposing plane. When the substrate holder is kept far from the ultraviolet ray generator, ultraviolet ray irradiation quantity is reduced at each irradiated area on the substrate but uniformity is increased. When the substrate is kept near, the ultraviolet ray irradiation quantity is increased but uniformity is reduced. Specifically, the ultraviolet ray irradiation quantity and uniformity can be adjusted by the vertical movement of the substrate holder. Furthermore, since the substrate holder performs rotational and counter rotational movement of 90 degrees or more to the ultraviolet ray generator or reciprocal linear movement within an opposing plane at the amplitude of 1/2 or integral multiple of a lamp installing interval, for example, unevenness of the ultraviolet ray irradiation quantity at each irradiated area can be eliminated and the ultraviolet ray irradiation quantity can be made even. Particularly, such constitution is effective when the ultraviolet ray irradiation quantity is different every place on a same substrate in the case of a larger-sized substrate or every substrate on a same substrate holder in case such that a plurality of substrates are processed simultaneously.

Still further, at least one of a supply source of nitrogen gas or inert gas, a supply source of oxygen gas, and a supply source of compound having siloxane bond is connected to the processing chamber.

Meanwhile, since oxygen molecules absorb ultraviolet ray having the wavelength of 200nm or less, ultraviolet ray irradiation intensity is reduced when their partial pressure in the processing chamber is high. Active oxygen (such as ozone and atomic oxygen) generated from oxygen molecules due to the absorption of ultraviolet ray causes the increase of relative dielectric constant by the oxidation of the low dielectric constant insulating film, deterioration by etching, or the like. Therefore, it is necessary to bring the residual oxygen concentration in the processing chamber to 0.01% or less of that in the atmosphere. To achieve it, the pressure of the processing chamber should be 10⁻² Torr or less. In this case, by repeating decompression of the processing chamber and purge by nitrogen gas or inert gas for one cycle or more, the partial pressure of oxygen molecules in the processing chamber can be reduced in a short time.

In addition, in a low dielectric constant insulating film made up of silicon oxide containing methyl group, organic molecules in the film are emitted by ultraviolet ray irradiation and annealing and then they adsorb on the protective tubes constituting the ultraviolet ray generator in the processing chamber and the inner wall of processing chamber. When organic matter adsorbs on the protective tubes of the ultraviolet ray generator, it absorbs ultraviolet ray and thus the irradiation intensity of ultraviolet ray is reduced. Further, when it adsorbs on the inner wall of the processing chamber, it falls off to cause particles. In this case, after ultraviolet ray is irradiated onto the substrate, oxygen gas or air containing oxygen gas is introduced into the processing chamber, and ultraviolet ray is irradiated on this state. Consequently, active oxygen is generated, and organic matter adsorbed on the protective tubes of the ultraviolet ray generator or on the inner wall of the processing chamber can be decomposed and removed.

Further, in the low dielectric constant insulating film made up of silicon oxide containing methyl group, methyl group is removed from the film by ultraviolet ray irradiation and annealing. In this case, anti-moisture-absorbing characteristic of the film is lowered if the concentration of methyl group is drastically reduced. In other words, when the film contacts the atmosphere, there is a fear that moisture in the atmosphere will adsorb onto the pore wall inside the film and the relative dielectric constant will be increased. To prevent this, after performing ultraviolet ray irradiation processing, compound containing siloxane bond, which is hexamethyldisiloxane (HMDSO) or the like, for example, is allowed to adsorb onto the surface of the low dielectric constant insulating film before taking the film out to the atmosphere, and thus the surface is made hydrophobic. This can prevent an infiltration of moisture into the pore inside the low dielectric constant insulating film and an adsorption of moisture on the pore wall.

Furthermore, the ultraviolet ray irradiation processing apparatus has means for heating the substrate. In this case, to obtain the low dielectric constant insulating film having large mechanical strength, ultraviolet ray is irradiated onto a substrate while heating the substrate on the process of cutting off CH₃ group from Si-CH₃ bond in the insulating film by irradiating ultraviolet ray onto the formed film having CH₃ group in the framework structure of Si-O-Si or the like, and thus CH₃ group can be cut off from Si-CH₃ bond in the insulating film and then CH₃ group that has been cut off can be immediately emitted to the outside of the film. At the same time, uncombined bond left on the pore wall by elimination of CHₙ group is recombined (polymerization), and the mechanical strength of the film can be further increased.

The semiconductor manufacturing system of the present invention is constituted by the combination of the above-described ultraviolet ray irradiation processing apparatus (when heating device is not provided) and a heating apparatus, the combination of a film forming apparatus and the above-described ultraviolet ray irradiation processing apparatus (when heating device is provided), or the combination of the film forming apparatus, the above-described ultraviolet ray irradiation processing apparatus (when heating device is not provided) and the heating apparatus, and the constituent apparatus are connected in series or in parallel via a transfer chamber in each combination. With this configuration, film forming, ultraviolet ray irradiation processing, and anneal processing can be performed continuously without exposing the substrate to the atmosphere.

Consequently, the increase of relative dielectric constant, deterioration of voltage withstand property, or the like caused by the adsorption of moisture or the like can be prevented in the formed film that has been formed by the semiconductor manufacturing systems.

### BRIEF DESCRIPTION OF THE DRAWINGS

Fig. 1A is a side view showing the constitution of an ultraviolet ray generator that is a first embodiment of the present invention, and Fig. 1B is a cross-sectional view taken along I-I line of Fig. 1A.
Fig. 2 is a cross-sectional view showing the constitution of an ultraviolet ray lamp that constitutes the ultraviolet ray generator that is the first embodiment of the present invention.
Fig. 3 is a side view showing the constitution of an ultraviolet ray irradiation processing apparatus that is a second embodiment of the present invention
Fig. 4 is a side view showing the constitution of another ultraviolet ray irradiation processing apparatus that is the second embodiment of the present invention.
Fig. 5 is a side view showing a semiconductor manufacturing system that is a third embodiment of the present invention.
Fig. 6 is a side view showing another semiconductor manufacturing system that is the third embodiment of the present invention.

### DETAILED DESCRIPTION OF THE PREFERRED EMBODIMENTS

Embodiments of the present invention will be explained with reference to the drawings hereinafter.

### (Explanation of the ultraviolet ray generator that is the first embodiment of the present invention)

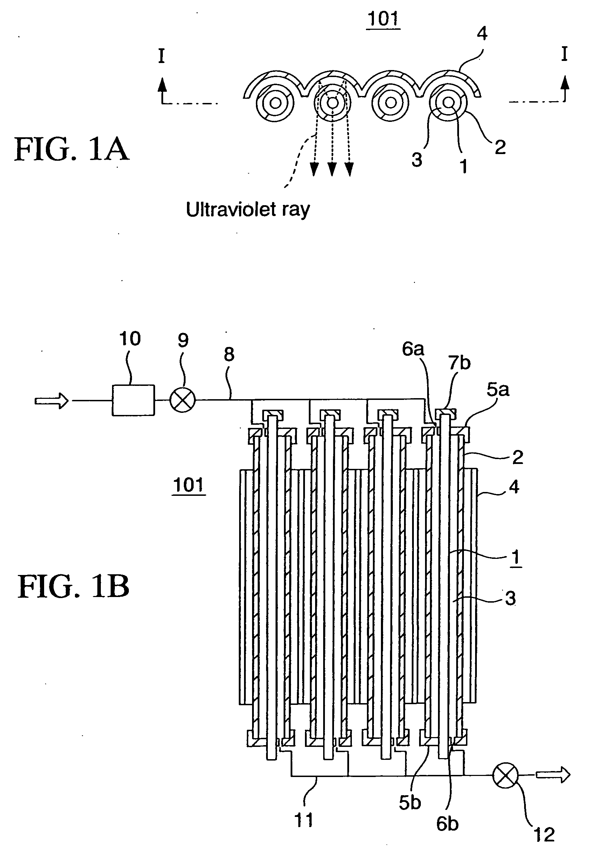

Fig. 1A is the side view showing the constitution of the ultraviolet ray generator according to the first embodiment of the present invention. Fig. 1B is the cross-sectional view taken along I-I line of Fig. 1A.

The ultraviolet ray generator 101, as shown in Figs. 1A and 1B, is provided with main bodies of four columnar ultraviolet ray lamps 1, four tubular protective tubes 2 made of quartz glass (material that transmits ultraviolet ray), each of which individually houses each ultraviolet ray lamp 1 and separates the ultraviolet ray lamp 1 from outside, and an ultraviolet ray reflective plate 4 that allows ultraviolet ray radially generated from the ultraviolet ray generator to travel in a specific direction (downward in Fig. 1A) by reflection. Note that the specific direction does not mean that all ultraviolet rays travel in a specific direction at a same angle, but means that the rays are allowed to travel to the ultraviolet ray generator side in spite of the different angle of each ultraviolet ray when viewed from the ultraviolet ray reflective plate. The same applies to the following.

Further, as shown in Fig. 1A, the main bodies of the columnar ultraviolet ray lamps 1 are inserted concentrically into the tubular protective tubes 2, and the both ends of main bodies of the ultraviolet ray lamps 1 are protruded from the both ends of the tubular protective tubes 2. Caps (5a, 5b) are covered on the both ends of the tubular protective tubes 2 via o-rings (not shown), the both ends of the main bodies of the ultraviolet ray lamps 1 are protruded from the caps (5a, 5b), and the inside of the protective tubes 2 are hermetically sealed. Further, the caps (5a, 5b) are respectively provided with gas introduction ports 6a for introducing nitrogen gas or inert gas from outside and gas exhaust ports 6b for exhausting nitrogen gas or inert gas in order to keep the inside of the protective tube 2, that is, a gap 3 between the ultraviolet ray lamp 1 and the protective tube 2, at atmospheric pressure and to keep the oxygen quantity of the gap 3 at a predetermined value or less. The gas introduction ports 6a are connected to a supply source (not shown) of nitrogen gas or inert gas via piping 8 provided with an open/close valve 9 and a mass flow controller 10. The gas exhaust ports 6b are connected to an exhaust device (not shown) via piping 11 provided with an open/close valve 12.

Furthermore, leading electrodes 7b of a pair of electrodes for allowing gas in the glass tubes to discharge and generate ultraviolet ray are provided on one ends of the ultraviolet ray lamps 1. Note that a filter (not shown) may be provided on a direction in which the ultraviolet ray is directed. The filter is capable of selecting a wavelength of a predetermined range from the ultraviolet ray, which has been generated from the ultraviolet ray lamps 1, and allowing ultraviolet ray of the selected wavelength to pass through the filter

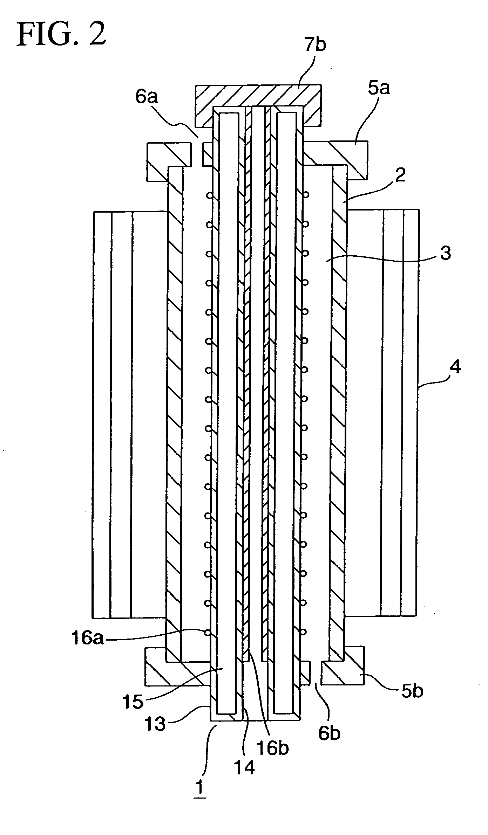

Next, the constitution of the main bodies of the ultraviolet ray lamps 1 will be explained in detail referring to Fig. 2.

A lamp already available in the market can be used as the main body of the ultraviolet ray lamp 1. As the main body of the ultraviolet ray lamp 1, a deuterium lamp, an excimer UV lamp that generates ultraviolet ray by high-frequency discharge of Ar or Xe, a mercury lamp, a mercury-xenon lamp, a laser (such as KrF laser, ArF laser, and F₂ laser), or the like may be used. Since ultraviolet ray generated from such lamp is not monochrome and its energy distributes in a wide range, it is desirable to pass ultraviolet ray through the filter depending on application and thus irradiate only ultraviolet ray having energy of a predetermined range. For example, in the case of intending to obtain the low dielectric constant insulating film having large mechanical strength, there is a fear that the bond of framework structure of an insulating film will be cut off by high-energy ultraviolet ray. To avoid this, it is desirable to irradiate ultraviolet ray via a filter that cuts high-energy ultraviolet ray that cuts off the bond of framework structure of the insulating film.

In this embodiment, an excimer UV lamp that generates ultraviolet ray by high-frequency discharge will be explained. Its constitution, as shown in Fig. 2, is that an inner tube 14 is inserted concentrically into a tubular outer tube 13, and space 15 between the inner tube 14 and the outer tube 13 is hermetically sealed and inert gas such as Ar and Xe is charged in the space. A mesh metal net electrode 16a is provided on the periphery of the outer tube so as to contact the wall of the outer tube 13, and a metal electrode 16b is provided on the inside of the inner tube 14 so as to contact the wall of the inner tube 14. The metal electrode 16b is connected to the leading electrode 7b. By applying voltage between the electrodes (16a, 16b) via the leading electrode 7b, the inert gas hermetically sealed in the space 15 between the outer tube 13 and the inner tube 14 discharges to generate ultraviolet ray from openings of the mesh of the metal net electrode 16a.

As described above, according to the ultraviolet ray generator 101 of the first embodiment of the present invention, one or more ultraviolet ray lamps 1 are individually housed in the protective tubes 2, which are made of a material that is transparent with respect to ultraviolet ray and separate the ultraviolet ray lamps 1 from the outside.

Therefore, when the outside of the protective tubes 2 of the ultraviolet ray generator 101 is decompressed, the protective tubes 2 can withstand the stress caused by the pressure difference, and this can prevent the ultraviolet ray lamps 1 inside the protective tubes 2 from breaking. In this case, the ultraviolet ray lamps 1 are one individually housed in the protective tubes 2, and thus when they are installed in the low-pressure atmosphere, the surface area of the protective tube 2, which contacts low-pressure atmosphere, can be made smaller. Accordingly, the stress applied to the protective tube 2, which is caused by the pressure difference, is also made smaller, and thus the thickness of the protective tube 2 can be even thinner. Consequently, the attenuation of ultraviolet ray transmitting intensity can be made smaller, and the cost of the ultraviolet ray generator 101 can be reduced.

Furthermore, the lamp has the gas introduction port 6a that introduces nitrogen gas or inert gas into the protective tube 2 from the outside. Therefore, nitrogen gas or the like is introduced into the gap 3 between the ultraviolet ray lamp 1 and the protective tube 2 to fill the gap 3 with nitrogen gas or the like, by which oxygen is not allowed to stay in the gap 3. Consequently, ultraviolet ray generated from the ultraviolet ray lamp 1 can be emitted to the outside of the protective tube 2 without suffering absorption by oxygen, and thus the attenuation of ultraviolet ray transmitting intensity can be made even smaller.

Moreover, electrodes 16a for discharge are exposed to the outside. Accordingly, if the protective tube 2 is not provided, there is a fear that they will contact the outside air or the atmosphere inside the processing chamber and thus be oxidized or corroded. Such problem can be solved by the protective tube 2.

Further, by providing the ultraviolet ray reflective plate 4 that allows ultraviolet ray radially generated from the ultraviolet ray generator 101 to travel in a specific direction by reflection, the usage efficiency of ultraviolet ray can be improved when the substrate is placed on a direction in which ultraviolet ray is directed.

Still further, by providing a filter capable of selecting a wavelength of a particular range and allowing the wavelength to pass through the filter, the energy (wavelength) of ultraviolet ray to be irradiated can be set to a predetermined range.

Meanwhile, the above-described ultraviolet ray generator 101 is constituted such that nitrogen gas or inert gas is introduced from the outside into the protective tube 2 in which the ultraviolet ray lamp 1 is housed, but it may be constituted such that the ultraviolet ray lamp 1 is sealed in the protective tube 2 and nitrogen gas or inert gas is previously charged in the tube.

### (Explanation of the ultraviolet ray irradiation processing apparatus that is the second embodiment of the present invention)

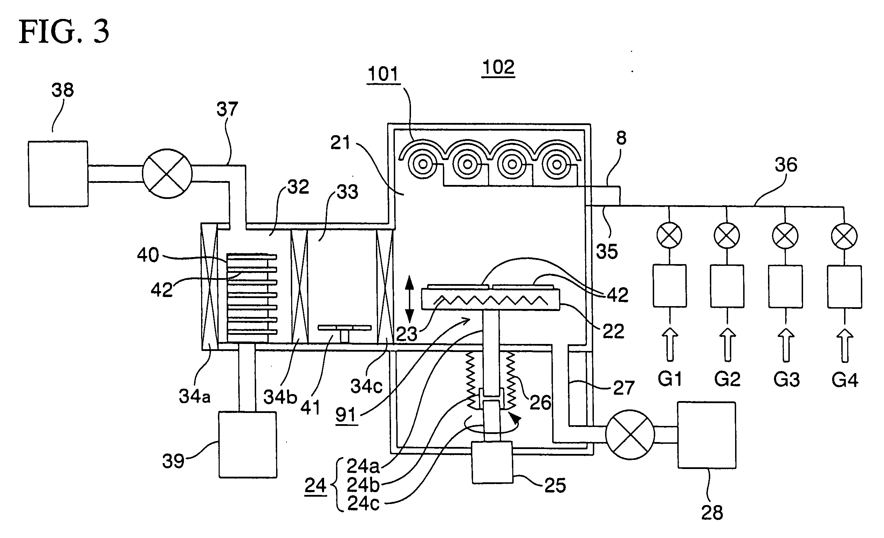

Fig. 3 is the side view showing the constitution of an ultraviolet ray irradiation processing apparatus 102 according to the second embodiment of the present invention.

The ultraviolet ray irradiation processing apparatus 102, as shown in Fig. 3, has a load lock chamber 32 that can be decompressed, a transfer chamber 33 that can be decompressed, and an ultraviolet ray irradiation processing chamber 21 that can be decompressed, and the chambers (32, 33, 21) are connected in series in this order. Communication/non-communication between the chambers is performed by open/close of gate valves (34b, 34c). In other words, the apparatus is capable of continuously performing ultraviolet ray irradiation processing and anneal processing in the low-pressure atmosphere without exposing a substrate 42 to the atmosphere.

The load-lock chamber 32 corresponds to an entrance/exit of the substrate 42 to the ultraviolet ray irradiation processing apparatus 102. It includes the gate valve 34a. The pressure inside the chamber is changed and then the gate valve 34a is opened or closed to carry in or carry out the substrate 42. The load-lock chamber 32 is connected to an exhaust pump 38 via exhaust piping 37, and includes moving means 39 that vertically moves the substrate 42 placed on a substrate holder 40. The transfer chamber 33 corresponds to a transfer route between the load-lock chamber 32 and the ultraviolet ray irradiation processing chamber 21, and includes a substrate transfer robot 41. The substrate transfer robot 41 transfers the substrate 42 from the load-lock chamber 32 to the ultraviolet ray irradiation processing chamber 21, and reversely from the ultraviolet ray irradiation processing chamber 21 to the load-lock chamber 32. The ultraviolet ray irradiation processing chamber 21 performs ultraviolet ray irradiation processing to the substrate 42, which has been carried in, under low pressure.

The ultraviolet ray irradiation processing chamber 21 is connected to an exhaust pump 28 through exhaust piping 27. An open/close valve for controlling communication/non-communication of the ultraviolet ray irradiation processing chamber 21 with the exhaust device 28 is provided halfway the exhaust piping 27.

The ultraviolet ray irradiation processing chamber 21 includes a substrate holder 91 and the ultraviolet ray generator 101 that opposes a substrate holding table 22 of the substrate holder 91. The substrate holder 91 comprises the substrate holding table 22, a rotational shaft 24, a motor 25, and a bellows 26. The rotational shaft 24 is composed of a first rotational shaft 24a connected to the substrate holding table 22, a second rotational shaft 24c connected to the motor 25, and connecting means 24b between the first rotational shaft 24a and the second rotational shaft 24c. The bellows 26 is provided around the rotational shaft 24 integrally with the rotational shaft 24, and expands and contracts with the vertical movement of the rotational shaft 24 to keep the hermetical sealing inside the chamber 21. Further, the connecting means 24b prevents the bellows 26 from being twisted when the rotational shaft 24 rotates. With this constitution, the substrate holding table can perform at least one of the vertical movement (back and forth movement to the ultraviolet ray generator 101) and the rotational and counter rotational movement with respect to the ultraviolet ray generator 101. Further, the chamber includes a shutter (not shown), which controls open/close of the path of ultraviolet ray, between the substrate holding table 22 and the ultraviolet ray generator 101. The substrate holding table 22 includes a heater (heating device) 23 based on resistive heating, which heats the substrate 42 on the substrate holding table 22.

Furthermore, the ultraviolet ray irradiation processing chamber 21 is connected to a nitrogen gas supply source G1, an inert gas supply source G2, an oxygen gas supply source G3, and a supply source G4 of compound having siloxane bond via piping 36 and branch piping 35. The open/close valve and the mass flow controller are provided halfway the piping 36. In addition, another piping 8 branched from the piping 36 is connected to the protective tubes 2 of the ultraviolet ray generator 101. Filling gas (nitrogen gas or inert gas) is supplied into the inside of the protective tubes 2, which is the gap 3 between the ultraviolet ray lamp 1 and the inner wall of the protective tube 2, via the piping (8, 36) not to allow oxygen to stay in the gap 3.

As described above, according to the ultraviolet ray irradiation processing apparatus of the second embodiment of the present invention, the ultraviolet ray generator 101 has the protective tubes 2 that house the ultraviolet ray lamps 1 one individually to separate them from the outside. Thus, the ultraviolet ray generator 101 can withstand the stress caused by the pressure difference because of the protective tubes 2, and the thickness of the protective tubes 2 can be made thinner, so that the attenuation of ultraviolet ray transmitting intensity can be made smaller, and the apparatus cost can be reduced.

Further, since the apparatus includes the ultraviolet ray reflective plate 4 to make ultraviolet ray travel downward by reflection, the usage efficiency of ultraviolet ray can be improved and power saving can be achieved eventually.

Moreover, since the apparatus includes the filter capable of selecting a wavelength of ultraviolet ray to be irradiated, it can irradiate only ultraviolet ray whose wavelength is in a specific range. Therefore, after forming a film having CH₃ group in the framework structure of Si-O-Si or the like, for example, CH₃ group can be cut off from Si-CH₃ bond in the insulating film without affecting the framework structure of Si-O-Si or the like of the formed film, and the low dielectric constant insulating film having large mechanical strength can be formed.

Further, the ultraviolet ray irradiation processing apparatus has the heating device 23 of the substrate. In this case, on the process of irradiating ultraviolet ray on the formed film where the framework structure of Si-O-Si or the like has CH₃ bond and thus cutting off CH₃ group from Si-CH₃ bond in the insulating film in order to obtain the low dielectric constant insulating film having large mechanical strength, ultraviolet ray is irradiated onto the substrate 42 while heating the substrate 42. Thus, CH₃ group can be cut off from Si-CH₃ bond in the insulating film and then the CH₃ group that has been cut off can be immediately emitted to the outside of the film. At the same time, the uncombined bond left on the pore wall by the elimination of CHₙ group is recombined (polymerization), and the mechanical strength of the film can be further increased.

Furthermore, the substrate holding table 22 is capable of performing at least one of the vertical movement (back and forth movement to the ultraviolet ray generator 101), and the rotational and counter rotational movement to the ultraviolet ray generator. When the substrate holding table 22 is kept far from the ultraviolet ray generator 101, ultraviolet ray irradiation quantity is reduced at each irradiated area on the substrate 42 but uniformity is increased. When the substrate is kept near therefrom, the ultraviolet ray irradiation quantity is increased but uniformity is reduced. Specifically, the ultraviolet ray irradiation quantity and uniformity can be adjusted by the vertical movement of the substrate holding table 22. Furthermore, when the substrate holding table 22 performs the rotational and counter rotational movement of 90 degrees or more to the ultraviolet ray generator 101, for example, unevenness of the ultraviolet ray irradiation quantity at each irradiated area can be eliminated and thus the ultraviolet ray irradiation quantity can be made even. Particularly, such constitution is effective in the case such that the ultraviolet ray irradiation quantity is different depending on areas in a same substrate when the substrate is manufactured at larger-size or in the case such that the ultraviolet ray irradiation quantity is different depending on areas on the surfaces of the substrates on the same substrate holding table 22 when a plurality of substrates 42 are mounted on a same substrate holding table 22.

Still further, at least one of the nitrogen gas supply source G1, the inert gas supply source G2, the oxygen gas supply source G3, and the supply source G4 of compound having siloxane bond is connected to the ultraviolet ray irradiation processing chamber 21.

Meanwhile, since oxygen molecules absorb ultraviolet ray having the wavelength of 200nm or less, ultraviolet ray irradiation intensity is reduced when their partial pressure in the ultraviolet ray irradiation processing chamber 21 is high. In addition, active oxygen (such as ozone and atomic oxygen) generated from oxygen molecules due to the absorption of ultraviolet ray causes the increase of relative dielectric constant by the oxidation of the low dielectric constant insulating film, deterioration by etching, or the like. Therefore, it is desirable to bring the residual oxygen concentration in the processing chamber to 0.01% or less of that in the atmosphere. To achieve it, the pressure of the processing chamber should be 10⁻² Torr or less. In this case, by repeating decompression of the ultraviolet ray irradiation processing chamber 21 and purge by nitrogen gas or inert gas for one cycle or more, the partial pressure of oxygen molecules in the ultraviolet ray irradiation processing chamber 21 can be reduced in a short time.

In addition, in the low dielectric constant insulating film made up of silicon oxide containing methyl group, organic matter in the film is emitted by ultraviolet ray irradiation and annealing, and then it adsorbs on the protective tubes 2 constituting the ultraviolet ray generator 101 in the ultraviolet ray irradiation processing chamber 21 and on the inner wall of ultraviolet ray irradiation processing chamber 21. When organic matter adsorbs on the protective tubes 2 of the ultraviolet ray generator 101, it absorbs ultraviolet ray and thus the irradiation intensity of ultraviolet ray is reduced. Further, when it adsorbs on the inner wall of the ultraviolet ray irradiation processing chamber 21, it falls off to cause particles. In this case, after ultraviolet ray is irradiated onto the substrate 42, oxygen gas or air containing oxygen gas is introduced into the ultraviolet ray irradiation processing chamber 21, and on this state ultraviolet ray is irradiated. Consequently, active oxygen is generated, and organic material adsorbed on the protective tubes 2 of the ultraviolet ray generator 101 or on the inner wall of the ultraviolet ray irradiation processing chamber 21 can be decomposed and removed.

Further, in the low dielectric constant insulating film made up of silicon oxide containing methyl group, methyl group is removed from the film by ultraviolet ray irradiation and annealing. In this case, the anti-moisture-absorbing characteristic of the film is lowered if the concentration of methyl group is drastically reduced. In other words, when the film contacts the atmosphere, there is a fear that moisture in the atmosphere will adsorb onto the pore wall inside the film and thus the relative dielectric constant will be increased. To prevent this, after performing ultraviolet ray irradiation processing, compound containing siloxane bond, which is hexamethyldisiloxane (HMDSO) or the like, for example, is allowed to adsorb onto the surface of the low dielectric constant insulating film before taking the film out to the atmosphere, and the surface and the pore wall are made hydrophobic. This can prevent infiltration of moisture into the pore inside the low dielectric constant insulating film and the adsorption of moisture on the film surface and the pore wall.

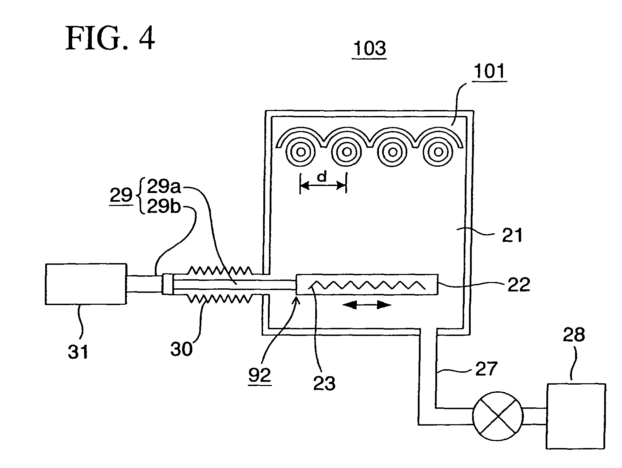

Next, the constitution of another ultraviolet ray irradiation processing apparatus 103 according to the second embodiment of the present invention will be explained referring to Fig. 4. Fig. 4 is the side view particularly showing the constitution of the ultraviolet ray irradiation processing chamber.

The apparatus is different from the apparatus of Fig. 3 in the point such that the substrate holding table 22 performs the reciprocal linear movement within an opposing plane at the amplitude of 1/2 or integral multiple of a lamp installing interval d. The substrate holding table 22 constitutes a part of a substrate holder 92. The substrate holder 92 comprises a support shaft 29 attached to the side portion of the substrate holding table 22, a motor 31 to which the support shaft 29 is attached, and a bellows 30 that expands and contracts by the movement of the support shaft 29. The support shaft 29 is composed of a tubular support shaft 29b and a support shaft 29a connected to the motor 31 through the inside of the shaft 29b. The bellows 30 is attached to the support shaft 29 so as to surround the periphery of the shaft. With this constitution, the rotational and counter rotational movement of the motor 31 is transformed into the reciprocal linear movement within an opposing plane of the substrate holding table 22 via the support shaft 29a.

Note that the constitution around the ultraviolet ray irradiation processing chamber 21 of Fig. 4 may be in the same constitution as the apparatus of Fig. 3.

According to another ultraviolet ray irradiation processing apparatus 103 according to the second embodiment of the present invention, the substrate holding table 22 performs the reciprocal linear movement within an opposing plane at the amplitude of 1/2 or integral multiple of the lamp installing interval d. Accordingly, unevenness of the ultraviolet ray irradiation quantity at each irradiated area can be eliminated and thus the ultraviolet ray irradiation quantity can be made even. Particularly, such constitution is effective when the substrate becomes larger-size and the ultraviolet ray irradiation quantity is different depending on areas on a same substrate.

Meanwhile, both of the ultraviolet ray irradiation processing apparatus (102, 103) include the heater (heating device) 23 based on resistive heating in the substrate holding table 22, but it may be provided on another position, or it may be heating device based on infrared ray or on another heating method. Alternatively, the heating device can be omitted from the ultraviolet ray irradiation processing apparatus (102, 103). When the heating device 23 is omitted from the ultraviolet ray irradiation apparatus (102, 103), an exclusive unit for heating can be provided and annealing can be performed using the unit after ultraviolet ray irradiation processing.

### (Explanation of the semiconductor manufacturing system that is the third embodiment of the present invention)

In the semiconductor manufacturing system of the present invention, there is a possibility of the combination of the ultraviolet ray irradiation processing apparatus according to the second embodiment whose heating device has been omitted, and the heating apparatus, the combination of the film forming apparatus and the ultraviolet ray irradiation processing apparatus of the second embodiment (when the heating device is provided), or the combination of the film forming apparatus and the ultraviolet ray irradiation processing apparatus of the second embodiment (when the heating device is not provided), and the systems can be constituted such that the constituent apparatus of each combination are connected in series in order or connected in parallel via the transfer chamber. A chemical vapor deposition apparatus (CVD apparatus) or a coating apparatus can be used as the film forming apparatus.

Of the above-described feasible system constitutions, the third embodiment is constituted by the combination of the film forming apparatus (film forming chamber), the ultraviolet ray irradiation processing apparatus (ultraviolet ray irradiation processing chamber) that is not provided with the heating device, and the heating apparatus (anneal chamber), and the constituent apparatus (chambers) are connected in series in order or in parallel via the transfer chamber. With this configuration, film forming, ultraviolet ray irradiation processing, and anneal processing can be performed continuously without exposing the substrate to the atmosphere.

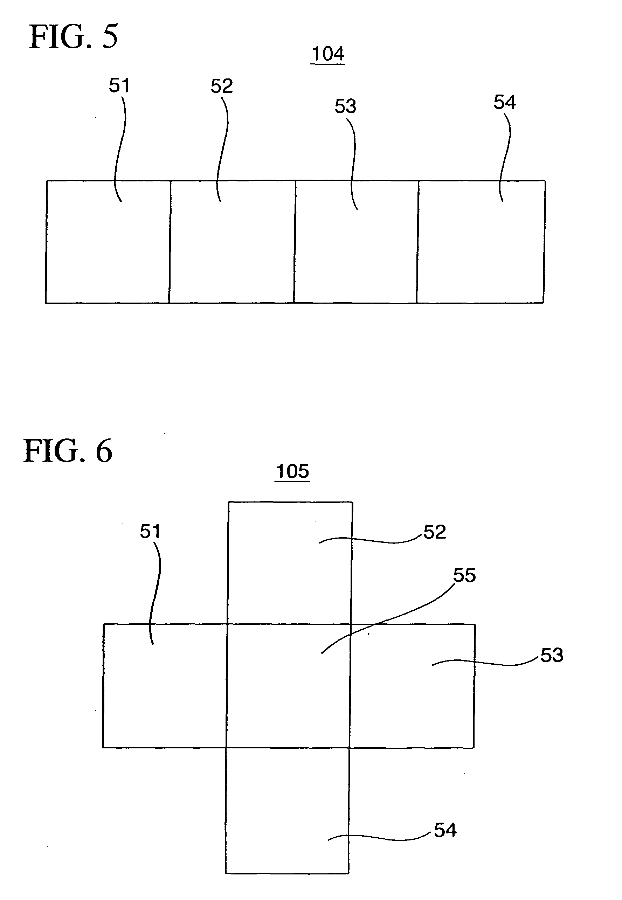

Fig. 5 is the schematic view showing the constitution of a semiconductor manufacturing system 104 whose constituent apparatus are connected in series in order, and Fig. 6 is the schematic view showing the constitution of a system 105 whose constituent apparatus are connected in parallel via the transfer chamber.

In the semiconductor manufacturing system 104 shown in Fig. 5, a load-lock chamber 51, a film forming chamber 52, an ultraviolet ray irradiation processing chamber 53, and an anneal chamber 54 are connected in series via the gate valve. Each chamber (51, 52, 53, 54) has a constitution required for its use application and transfer means of substrate, and is capable of adjusting pressure individually. With this configuration, film forming, ultraviolet ray irradiation processing, and anneal processing can be performed continuously under the low pressure without exposing the substrate to the atmosphere.

In the semiconductor manufacturing system 104 shown in Fig. 6, the load-lock chamber 51, the film forming chamber 52, the ultraviolet ray irradiation processing chamber 53, and the anneal chamber 54 are provided around a transfer chamber 55, each chamber (51 to 54) is connected in parallel to the transfer chamber 55 via the gate valve. With this configuration, film forming, ultraviolet ray irradiation processing, and anneal processing can be performed continuously under the low pressure without exposing the substrate to the atmosphere.

As described above, according to the semiconductor manufacturing system that is the third embodiment, film forming, ultraviolet ray irradiation processing, and anneal processing can be performed continuously without exposing the substrate to the atmosphere, so that the increase of relative dielectric constant, deterioration of voltage withstand property, or the like caused by the adsorption of moisture or the like can be prevented in the formed film. Consequently, it is possible to provide a low-cost semiconductor manufacturing system that is capable of forming a low dielectric constant insulating film or a nitride film having good film quality and large mechanical strength.

### (Explanation of the method of forming a low dielectric constant insulating film that is the fourth embodiment of the present invention)

Next, the method of forming a low dielectric constant insulating film that is the fourth embodiment of the present invention will be explained. In this method, either one of the semiconductor manufacturing systems (104, 105) shown in Fig. 5 or Fig. 6, which have been explained in the third embodiment, can be used.

First of all, the entire process for forming the low dielectric constant insulating film will be explained.

The substrate (substrate subject to processing) is carried into the film forming chamber 52 first, a porous or a non-porous insulating film that contains Si-CHₙ (n=1, 2, 3) bond in Si-O-Si or another silica framework structure is formed on the substrate. In this case, there are the following two types as a film forming method.
(a) Using a parallel plate plasma enhanced CVD system, film forming gas containing siloxane compound or another organic compound, which has Si-CH₃ bond, is introduced between opposing electrodes, then electric power is applied between the opposing electrodes to generate plasma, and thus reaction is caused to form a CVD insulating film containing Si-CHₙ bond on the substrate.
(b) Organic SOG containing siloxane and having Si-CH₃ bond is coated on the substrate by a spin coating, a coated film that has been formed is heated to evaporate solvent, and thus a coated insulating film containing Si-CHₙ bond is formed.

Subsequently, the substrate is moved from the film forming chamber 52 to the ultraviolet ray irradiation processing chamber 53, and the pressure inside the ultraviolet ray irradiation processing chamber 53 is kept at 10⁻² Torr or less, preferably at 10⁻³ Torr or less. Then, ultraviolet ray is irradiated on the formed insulating film in the low-pressure atmosphere to cut off CHₙ group from Si-CHₙ bond in the insulating film. In this case, the wavelength of the ultraviolet ray shall be at the range of 120nm or more to 200nm or less. The wavelength is equivalent to the energy of 10eV or less, and matches an energy range in which CHₙ group can be eliminated from Si-CHₙ bond without affecting the framework structure of Si-O-Si or the like. Due to ultraviolet ray irradiation, in the case of the non-porous film, free volume (referred to as pore depending on size) becomes larger because of the elimination of CHₙ group and thus the dielectric constant of the film is reduced. Further, in the case of the porous film, pore volume becomes larger because of the elimination of CHₙ group, and thus porosity is increased and the dielectric constant of the film is reduced.

Next, the substrate is moved from the ultraviolet ray irradiation processing chamber 53 to the anneal chamber 54, and CHₙ group cut off from the insulating film is discharged. For example, substrate heating temperature is set to normal temperature to 450°C, preferably from 100 to 450°C. As a result, CH₃ group that has been cut off is removed from the insulating film. At the same time, the uncombined bond left on the pore wall due to the elimination of CHₙ group is recombined (polymerization) by annealing, and thus the mechanical strength of the film can be further increased. Consequently, the low dielectric constant insulating film having excellent mechanical strength is formed. Meanwhile, the reason why the upper limit of the substrate heating temperature is set to 450°C is to prevent change-in-quality of material itself or reaction with surrounding matter when copper, aluminum, or the like has already been formed. Further, the lower limit of the temperature may be the normal temperature or more, and CHₙ group can be removed faster when it is set to 100°C or higher.

When the heating device is added to the ultraviolet ray irradiation processing chamber 53 in the above-described semiconductor manufacturing apparatus and the heating chamber 54 is omitted therein, it can bring a series of the processes into an integrated performance of both the process of irradiating ultraviolet ray to cut off CH₃ group from Si-CH₃ bond in the insulating film and the process of discharging CH₃ group that has been cut off from the insulating film. In this case, ultraviolet ray is irradiated while the substrate is heated. This accelerates the diffusion of CH₃ group that has been eliminated and the emission to the outside of the film. At the same time, the uncombined bond left on the pore wall is recombined (polymerization) by annealing, and the mechanical strength of the film can be further increased.

Meanwhile, when the semiconductor manufacturing system 105 of Fig. 6 is used particularly, the above-described series of the processes can be performed repeatedly without exposing the substrate to the atmosphere. It enables formation of a multi-layered structure of the low dielectric constant insulating film of this embodiment, and thus results in formation of a low dielectric constant insulating film entirely having a thick film thickness.

Specific examples for Film forming conditions of a low dielectric constant insulating film having excellent mechanical strength will be explained as follows.

### (1) First Example

A silicon oxide film was formed on a silicon substrate on the film forming conditions of plasma-enhanced CVD shown below, and ultraviolet ray irradiation processing was performed under the following ultraviolet ray processing conditions.

### (Film forming conditions I)

(i) Film forming gas conditions
   HMDSO gas flow rate: 50 sccm
   H₂O gas flow rate: 1000 sccm
   C₄F₈ gas flow rate: 50 sccm
   Gas pressure: 1.75 Torr
(ii) Conditions for generating plasma
   High-frequency power (frequency: 13.56 MHz) PHF: 300W

   Low-frequency power (380 KHz) PLF: 0W
(iii) Substrate heating temperature: 375°C
(iv) Silicon oxide film deposited
   Film thickness: 650nm

### (Ultraviolet ray processing conditions)

(i) Ultraviolet ray source: Deuterium lamp
   Ultraviolet ray wavelength: 120 to 400nm
   Power: 30W
(ii) Substrate heating: 400°C
(iii) Processing time: 30 minutes

As a result, an average pore size that was 1.22nm before ultraviolet ray processing became 1.36nm after ultraviolet ray processing. Further, Young's modulus of 12.73 GPa and hardness of 1.87 GPa before ultraviolet ray processing became Young's modulus of 23.98 GPa and hardness of 3.01 GPa after ultraviolet ray processing. Thus, it was possible to maintain/improve film strength and to reduce relative dielectric constant by ultraviolet ray irradiation.

Note that the improvement of film strength, which is considered to be caused by the recombination of uncombined bonds from which methyl group is eliminated, was observed in this embodiment. However, if such recombination reaction occurs too much, there is a fear such that due to shrinkage and higher density of film, the film is brought into an increase of relative dielectric constant contrarily in some cases. Further, since methyl group has a function to improve moisture resistance, removing all methyl groups is not necessarily good to the low dielectric constant insulating film. Therefore, it is necessary to adjust frequency at which recombination reaction occurs and the quantity of methyl groups to be removed. The adjustment can be performed by adjusting ultraviolet ray irradiation quantity (such as electric power and irradiation time).

### (2) Second Example

In the second example, the silicon oxide film was formed under the following film forming conditions by the plasma-enhanced CVD method.

### (Film forming conditions II)

(i) Film forming gas conditions
   HMDSO gas flow rate: 50 sccm
   H₂O gas flow rate: 1000 sccm
   Gas pressure: 1.75 Torr
(ii) Conditions for generating plasma
   High-frequency power (frequency: 13.56 MHz) PHF: 300W
   Low-frequency power (380 KHz) PLF: 0W
(iii) Substrate heating temperature: 375°C
(iv) Silicon oxide film deposited
   Film thickness: 650nm

### (Ultraviolet ray processing conditions)

(i) Ultraviolet ray source: Deuterium lamp
   Ultraviolet ray wavelength: 120 to 400nm
   Power: 30W
(ii) Substrate heating: 200°C, 400°C
(iii) Processing time: 20 minutes

As a result, the pore size that was 0.96nm before ultraviolet ray irradiation became 1.02nm at the substrate heating temperature of 200°C and 1.17nm at 400°C after ultraviolet ray irradiation. Further, the relative dielectric constant that was about 2.58 before ultraviolet ray irradiation was reduced to 2.42 after ultraviolet ray irradiation.

Consequently, it was made clear that larger pore size could be obtained when the substrate heating temperature was set as high as possible within a range where the framework structure of the insulating film is not affected. With this conditions, a lower relative dielectric constant is expected.

### (3) Third Example

In the third example, the silicon oxide film was formed under the following film forming conditions by the plasma-enhanced CVD method.

### (Film forming conditions III)

(i) Film forming gas conditions
   HMDSO gas flow rate: 50 sccm
   H₂O gas flow rate: 1000 sccm
   C₂H₄ gas flow rate: 50 sccm
   Gas pressure: 1.75 Torr
(ii) Conditions for generating plasma
   High-frequency power (frequency: 13.56 MHz) PHF: 300W
   Low-frequency power (380 KHz) PLF: 0W
(iii) Substrate heating temperature: 400°C
(iv) Silicon oxide film deposited
   Film thickness: 650nm

### (Ultraviolet ray processing conditions)

(i) Ultraviolet ray source: Deuterium lamp
   Ultraviolet ray wavelength: 120 to 400nm
   Power: 30W
(ii) Substrate heating: 400°C
(iii) Processing time: 30 minutes

As a result, the relative dielectric constant that was about 2.66 before ultraviolet ray irradiation was reduced to 2.45 after ultraviolet ray irradiation. In this embodiment, the reason of large reduction ratio of the relative dielectric constant is considered that the concentration of methyl group in the insulating film was high because source gas contained C₂H₄ gas and this caused large production quantity of pores. In other words, it can be concluded that an insulating film having larger content of weak bond group before irradiating ultraviolet ray has larger effect of reducing relative dielectric constant corresponding to the larger content of weak bond group.

### (4) Fourth Example

In the fourth embodiment, the silicon oxide film was formed under the following film forming conditions by the coating method.

### (Film forming conditions IV)

(i) Coating conditions
   Coating solution: Alkylsilsesquioxane polymer (MSQ)
   Rotation speed: 2000 to 3000 rpm
(ii) Heating processing condition after coating
   Heating temperature: 400°C
(iii) Silicon oxide film deposited
   Film thickness: 400nm

### (Ultraviolet ray processing conditions)

(i) Ultraviolet ray source: Deuterium lamp
   Ultraviolet ray wavelength: 120 to 400nm
   Power: 30W
(ii) Substrate heating: 400°C
(iii) Processing time: 30 minutes

As a result, the average pore size that was 0.81nm before ultraviolet ray irradiation became 1.11nm after ultraviolet ray irradiation. Specifically, it was confirmed that the pore size became larger by ultraviolet ray irradiation on a coated silicon oxide film formed by the coating method using MSQ. The coated silicon oxide film also has the structure where methyl group bonds to a part of the silica network structure (framework structure) of Si-O-Si, and it is considered that the pore size became larger when methyl group was eliminated by ultraviolet ray irradiation without affecting the framework structure.

As described above, according to the fourth embodiment of the present invention, it is based on at first forming an insulating film having sturdy structure of Si-O-Si and including Si-CH₃ bond by the plasma-enhanced CVD method or the coating method, and then CH₃ group is cut off from Si-CH₃ bond in the insulating film not by oxidation but by irradiating ultraviolet ray onto the insulating film in the low-pressure atmosphere, and is further discharged from the insulating film.

In this case, by providing with the filter capable of selecting the wavelength of ultraviolet ray to be irradiated, the energy of the irradiating ultraviolet ray is made higher than the bond energy of Si-CH₃ bond group and lower than the bond energy of Si-O-Si that forms the framework structure. With this, CH₃ group can be cut off from Si-CH₃ bond in the insulating film without affecting the framework structure of the insulating film.

Consequently, it is possible to maintain or improve the strength of insulating film and to lower the relative dielectric constant of insulating film.

The present invention has been explained above in detail based on the embodiments, but the scope of the invention is not limited to the examples specifically shown in the above-described embodiments, and modifications of the above-described embodiments within a scope without departing from the gist of the invention are incorporated in the scope of the present invention.

For example, the above-described embodiments have the ultraviolet ray reflective plate 4, but it may be omitted.

Further, the invention is applied for the method of forming a low dielectric constant insulating film, but it is applicable to a method of adjusting the relative dielectric constant of a nitride film by irradiating ultraviolet ray onto the nitride film, or a method of improving etching resistance of a resist film.

In the ultraviolet ray generator of the present invention, the ultraviolet ray lamp is individually sealed or housed in the protective tube made of a material that is transparent with respect to ultraviolet ray. Due to this constitution, particularly in the case where a plurality of ultraviolet ray lamps are arranged and ultraviolet ray generator is installed in the low-pressure atmosphere, the thickness of the protective tubes can be made thinner, so that the attenuation of ultraviolet ray transmitting intensity can be smaller and the cost of ultraviolet ray generator can be reduced.

Furthermore, nitrogen gas or inert gas is previously charged in the protective tube, or the protective tube has the gas introduction port for introducing nitrogen gas or inert gas in the tube. Therefore, when ultraviolet ray is irradiated, the gap is in a state such that oxygen is not left therein, or the gap is filled with nitrogen gas or the like and thus oxygen-free state can be created in the gap. Thus, ultraviolet ray generated from the ultraviolet ray lamp can be emitted without being absorbed by oxygen. This can make the attenuation of ultraviolet ray transmitting intensity smaller.

In the ultraviolet ray irradiation processing apparatus of the present invention, the substrate holder that holds the substrate in the processing chamber whose pressure can be decompressed and the above-described ultraviolet ray generator is provided in the processing chamber so as to oppose the substrate holder. Since the ultraviolet ray generator can withstand the stress caused by the pressure difference even if the thickness of the protective tube is made thin, the attenuation of ultraviolet ray transmitting intensity can be suppressed and the apparatus cost can be reduced.

Further, the substrate holder is capable of performing at least one of the vertical movement, the rotational movement to the ultraviolet ray generator, and the reciprocal linear movement within an opposing plane. Therefore, the ultraviolet ray irradiation quantity and the uniformity can be adjusted by the vertical movement of the substrate holder, and the unevenness of the ultraviolet ray irradiation quantity at each irradiated area can be eliminated and the ultraviolet ray irradiation quantity can be unified by the rotational movement or the reciprocal linear movement within an opposing plane. Consequently, such constitution is particularly effective in the case where the ultraviolet ray irradiation quantity becomes different within a same substrate when a substrate becomes larger-size, or becomes different on every substrate surface on a same substrate holder when a plurality of substrates are processed simultaneously.

The semiconductor manufacturing system of the present invention is constituted by the combination of the above-described ultraviolet ray irradiation processing apparatus (when heating device is not provided) and the heating apparatus, the combination of the film forming apparatus and the above-described ultraviolet ray irradiation processing apparatus (when heating device is provided), or the combination of the film forming apparatus, the above-described ultraviolet ray irradiation processing apparatus (when heating device is not provided) and the heating apparatus, and the constituent apparatus are connected in series or in parallel via the transfer chamber in each combination. With these combinations, film forming, ultraviolet ray irradiation processing and anneal processing can be performed continuously without exposing the substrate to the atmosphere. Thus, the increase of relative dielectric constant, deterioration of voltage withstand property, or the like caused by the adsorption of moisture in the atmosphere or the like can be prevented in the formed film formed by the semiconductor manufacturing system. Consequently, it is possible to provide the low-cost semiconductor manufacturing system that is capable of forming the low dielectric constant insulating film or the nitride film having good film quality and large mechanical strength.

## Claims

1. An ultraviolet ray generator, comprising:
an ultraviolet ray lamp (1); and
a protective tube (2) being made of a material which is transparent with respect to ultraviolet ray, sealing said ultraviolet ray lamp, and being charged with nitrogen gas or inert gas.

2. An ultraviolet ray generator, comprising:
an ultraviolet ray lamp (1);
a protective tube (2) being made of a material which is transparent with respect to ultraviolet ray, and housing said ultraviolet ray lamp; and
a gas introduction port (6a) introducing nitrogen gas or inert gas into said protective tube (2).

3. The ultraviolet ray generator according to any one of claims 1 and 2, wherein
said ultraviolet ray lamp (1) of a columnar shape is housed in said protective tube (2) of a tubular shape.

4. The ultraviolet ray generator according to claim 3, wherein
a plurality of said ultraviolet ray lamps (1) one individually housed in said protective tubes (2) are arranged in parallel.

5. The ultraviolet ray generator according to any one of claims 3 and 4, wherein
said ultraviolet ray lamp (1) is excimer ultraviolet ray lamp that generates ultraviolet ray by discharge.

6. The ultraviolet ray generator according to any one of claims 1 to 5, wherein
said ultraviolet ray generator (101) is provided with an ultraviolet ray reflective plate (4) that allows ultraviolet ray generated from said ultraviolet ray generator (101) to travel in a specific direction by reflection.

7. The ultraviolet ray generator according to any one of claims 1 to 6, wherein
said ultraviolet ray generator (101) is provided with a filter that selects a wavelength of a specific range from ultraviolet ray generated from said ultraviolet ray generator (101) and passes said selected ultraviolet ray through said filter.

8. An ultraviolet ray irradiation processing apparatus, comprising:
a processing chamber (21) whose pressure can be decompressed;
a substrate holder (91), (92) provided in said processing chamber (21), and holding a substrate (42) onto which ultraviolet ray is irradiated; and
said ultraviolet ray generator (101) according to any one of claims 1 to 7, which is provided in said processing chamber (21) so as to oppose said substrate holder (91), (92).

9. The ultraviolet ray irradiation processing apparatus according to claim 8, wherein
said substrate holder (91), (92) is capable of performing at least one of vertical movement, rotational movement to said ultraviolet ray generator (101), and reciprocal linear movement within an opposing plane.

10. The ultraviolet ray irradiation processing apparatus according to any one of claims 8 and 9, wherein
at least one of a supply source (G1), (G2) of nitrogen gas or inert gas, a supply source (G3) of oxygen gas, and a supply source (G4) of siloxane compound is connected to said processing chamber (21).

11. The ultraviolet ray irradiation processing apparatus according to any one of claims 8 to 10, wherein
said ultraviolet ray irradiation processing apparatus (102), (103) has a heating device (23) of said substrate (42).

12. A semiconductor manufacturing system, wherein
said ultraviolet ray irradiation processing apparatus (53) according to any one of claims 8 to 10 and a heating apparatus (54) are connected in series, or connected in parallel via a transfer chamber (55),
whereby said semiconductor manufacturing system (104), (105) is capable of continuously performing ultraviolet ray irradiation processing and heating processing without exposing said substrate to the atmosphere.

13. A semiconductor manufacturing system, wherein
a film forming apparatus (52) and said ultraviolet ray irradiation processing apparatus (53) according to any one of claims 8 to 11 are connected in series, or connected in parallel via a transfer chamber (55),
whereby said semiconductor manufacturing system (104), (105) is capable of continuously performing film forming, ultraviolet ray irradiation processing and heating processing without exposing said substrate to the atmosphere.

14. A semiconductor manufacturing system, wherein
a film forming apparatus (52), said ultraviolet ray irradiation processing apparatus (53) according to any one of claims 8 to 10, and a heating apparatus (54) are connected in series, or connected in parallel via a transfer chamber (55),
whereby said semiconductor manufacturing system (104), (105) is capable of continuously performing, ultraviolet ray irradiation processing, and heating processing without exposing said substrate to the atmosphere.

15. The semiconductor manufacturing apparatus according to any one of claims 13 and 14, wherein
said film forming apparatus (52) is a chemical vapor deposition apparatus or a coating apparatus.
